(19) Europäisches Patentamt
European Patent Office
Office européen des brevets

(11) EP 1 598 701 A1

(12) EUROPEAN PATENT APPLICATION
published in accordance with Art. 158(3) EPC

(43) Date of publication:
**23.11.2005 Bulletin 2005/47**

(21) Application number: **04714426.6**

(22) Date of filing: **25.02.2004**

(51) Int Cl.[7]: **G03F 7/004**, G03F 7/038, G03F 7/039

(86) International application number:
**PCT/JP2004/002179**

(87) International publication number:
**WO 2004/077158 (10.09.2004 Gazette 2004/37)**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **25.02.2003 JP 2003047765**
**17.10.2003 JP 2003357581**

(71) Applicant: **TOKYO OHKA KOGYO CO., LTD.**
**Kawasaki-shi Kanagawa 211-0012 (JP)**

(72) Inventors:
- **HIRAYAMA, Taku,**
**c/o Tokyo Ohka Kogyo Co. Ltd.**
**Kawasaki-shi, Kanagawa 211-0012 (JP)**
- **FUJIMURA, Satoshi,**
**c/o Tokyo Ohka Kogyo Co. Ltd.**
**Kawasaki-shi, Kanagawa 211-0012 (JP)**
- **ENDO, Kotaro, c/o Tokyo Ohka Kogyo Co. Ltd.**
**Kawasaki-shi, Kanagawa 211-0012 (JP)**
- **ISHIDUKA, Keita, c/o Tokyo Ohka Kogyo Co. Ltd.**
**Kawasaki-shi, Kanagawa 211-0012 (JP)**

(74) Representative: **Poulin, Gérard et al**
**BREVALEX**
**3, rue du Docteur Lancereaux**
**75008 Paris (FR)**

# (54) PHOTORESIST COMPOSITION AND METHOD OF FORMING RESIST PATTERN

(57) There is provided a positive photoresist composition for use in a method of forming a resist pattern that includes an immersion lithography step, which exhibits little line edge roughness and an excellent resist pattern profile. This photoresist composition includes a resin component (A), an acid generator component (B), an organic solvent (C), and a nitrogen-containing organic compound (D) represented by a general formula (1) shown below:

[Formula]

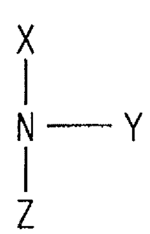

· · · (1)

[wherein, X, Y, and Z each represent, independently, an alkyl group that may contain an aryl group bonded to a terminal (although two terminals from the groups X, Y, and Z may also be bonded together to form a cyclic structure), at least one of X, Y, and Z contains a polar group, and the molecular weight of the compound (D) is at least 200].

EP 1 598 701 A1

## Description

### TECHNICAL FIELD

The present invention relates to a photoresist composition used in a method of forming a resist pattern that includes an immersion lithography (immersion exposure) step, and a method of forming a resist pattern that uses such a photoresist composition.

### BACKGROUND ART

Lithography techniques are widely used in the production of microscopic structures in a variety of electronic devices such as semiconductor devices and liquid crystal devices, and ongoing miniaturization of these device structures has lead to demands for further miniaturization of the resist patterns used in these lithography processes.

With current lithography techniques, using cutting edge technologies, fine resist patterns with a line width of approximately 90 nm are able to be formed, but in the future even finer pattern formation will be required.

In order to enable the formation of ultra fine patterns of less than 90 nm, the development of appropriate exposure apparatus and corresponding resists is the first requirement. In terms of exposure apparatus, apparatus with shorter wavelength light sources such as $F_2$ excimer lasers, EUV (extreme ultraviolet), electron beams and X-rays, or apparatus with larger lens apertures (NA) are common.

However, reducing the wavelength of the light source requires a new and expensive exposure apparatus, and new resists that are ideal for that light source must also be developed. Furthermore, if the NA value of the lens is increased, then because the resolution and the depth of focus exist in a trade-off type relationship, even if the resolution is increased, the depth of focus decreases.

Against this background, a method known as immersion lithography has been reported (for example, see the non-patent reference 1, the non-patent reference 2, and the non-patent reference 3). This is a method in which, during exposure, the region between the lens and the resist layer disposed on top of the wafer, which has conventionally been filled with air or an inert gas such as nitrogen, is filled with a solvent such as pure water or a fluorine-based inert liquid, which has a larger refractive index than the refractive index of air. By filling this region with this type of solvent, it is claimed that higher resolutions equivalent to those obtained using a shorter wavelength light source or a larger NA lens can be obtained using the same exposure light source wavelength, with no reduction in the depth of focus.

Using this type of immersion lithography, resist patterns with higher resolution and a superior depth of focus can be formed at low cost, using lenses mounted in conventional apparatus, and consequently the method is attracting considerable attention.

Furthermore, as described below in the patent references 1 and 2, incorporating a basic compound within a chemically amplified photoresist as a diffusion control agent for the acid generated from an acid generator is common practice.

(Non-Patent Reference 1) Journal of Vacuum Science and Technology B (U.S.), 1999, vol. 17, issue 6, pp. 3306-3309.

(Non-Patent Reference 2) Journal of Vacuum Science and Technology B (U.S.), 2001, vol. 19, issue 6, pp. 2353-2356.

(Non-Patent Reference 1) Proceedings of SPIE (U.S.), 2002, vol. 4691, pp. 459-465.

(Patent Reference 1) Japanese Unexamined Patent Application, First Publication No. 2002-179731

(Patent Reference 2) Japanese Unexamined Patent Application, First Publication No. 2002-333715

As described above, an advantage of immersion lithography is that large benefits are expected in the production of semiconductor elements. However, because the resist layer comes in contact with a solvent during exposure as described above, factors such as degeneration of the resist layer, or the leaching of components from the resist layer that have a deleterious effect on the solvent, mean it remains unclear whether or not immersion lithography is capable of forming a resist pattern of equivalent quality to those produced by conventional exposure processes.

### DISCLOSURE OF INVENTION

The inventors of the present invention recognized that if a resist composition containing, from amongst the conventional basic compounds, a tertiary lower amine with a polar group, such as a low molecular weight alkanolamine, was applied to immersion lithography, then problems of inadequate resist pattern shape and line edge roughness (hereafter also abbreviated as LER) occurred, and they developed the present invention to resolve these problems.

In other words, the present invention takes the problems associated with the conventional technology into consideration, with an object of providing a positive photoresist composition for use in a method of forming a resist pattern that includes an immersion lithography step, wherein the composition is resistant to the deleterious effects of

the solvent used in the immersion lithography step and exhibits little line edge roughness and excellent resist pattern profile, while retaining the advantages offered by immersion lithography of improved resolution and depth of focus, as well as providing a method of forming a resist pattern that uses such a resist composition.

As a result of intensive investigations aimed at achieving the above object, the inventors of the present invention discovered that they were able to achieve the object with the technology described below, and were hence able to complete the present invention.

In other words, a first aspect of the present invention is a photoresist composition used in a method of forming a resist pattern that includes an immersion exposure step, comprising a resin component (A) that undergoes a change in alkali solubility under the action of acid, an acid generator component (B) that generates acid on exposure, an organic solvent (C) capable of dissolving the component (A) and the component (B), and a nitrogen-containing organic compound (D) represented by a general formula (1) shown below.

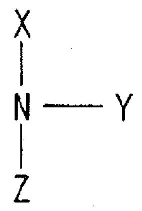

···(1)

[wherein, X, Y, and Z each represent, independently, an alkyl group that may contain an aryl group bonded to a terminal (although two terminals from the groups X, Y, and Z may also be bonded together to form a cyclic structure), at least one of X, Y, and Z contains a polar group, and the molecular weight of the compound (D) is at least 200.]

A second aspect of the present invention is a method of forming a resist pattern using a photoresist composition according to the first aspect that includes a step for conducting immersion exposure.

The term "(meth)acrylic acid" refers to either one of, or both methacrylic acid and acrylic acid. The term "(meth)acrylate refers to either one of, or both methacrylate and acrylate. The term "structural unit" refers to a monomer unit that contributes to the formation of a polymer. Furthermore, the term "lactone unit" refers to a group in which one hydrogen atom has been removed from a monocyclic or polycyclic lactone. A lithography process typically includes sequential steps for resist application, prebaking, selective exposure, post exposure baking, and alkali developing.

Effects of the Invention

According to the present invention, a high precision resist pattern which exhibits no surface roughening of the resist pattern such as the formation of T-top shaped patterns, and displays minimal line edge roughness and an excellent resist pattern profile can be produced using an immersion lithography process. Accordingly, by using a photoresist composition of the present invention, resist pattern formation that includes an immersion lithography step can be carried out effectively.

BEST MODE FOR CARRYING OUT THE INVENTION

As follows is a more detailed description of the present invention.

[Photoresist Composition]

- Component (D)

A photoresist composition of the present invention is characterized by the inclusion of the component (D).

Conventionally, nitrogen-containing organic compounds have been added to photoresist compositions as acid diffusion control agents to improve the resist pattern shape and the post exposure stability of the latent image formed by the pattern-wise exposure of the resist layer, but in the present invention, by selecting a specific nitrogen-containing organic compound and blending this compound into the photoresist composition, the object of the present invention can be achieved, and characteristics suited to immersion lithography can be obtained.

The component (D) is a compound represented by the above general formula (1). By ensuring that at least one of the groups X, Y, and Z contains a polar group, and that the compound has a specific molecular weight, the component (D) becomes resistant to volatilization following prebaking, and is easily retained within the resist film, and even following immersion exposure, the component is still easily retained within the resist film, meaning when the

composition is used with immersion lithography, effects such as minimal surface roughness, little line edge roughness, and an excellent resist pattern profile can be obtained.

The molecular weight of the component (D) is preferably at least 200, and even more preferably at least 250, and most preferably 300 or greater, as such values yield excellent resolution. There is no particular restriction on the upper limit for the molecular weight provided the effects described above are retained, although the molecular weight is preferably no more than 600.

If the molecular weight exceeds 600, there is a danger that the solubility of the component within the resist solvent may deteriorate.

The polar group is a group which, when compared with an unsubstituted alkyl group or aryl group, causes the component (D) to exhibit the aforementioned characteristics of being resistant to volatilization following prebaking and easily retained within the resist film (resist layer), and specific examples include an ether group, ester group, hydroxyl group, carbonyl group, carboxyl group, cyano group, or lactone ring.

Of these groups, an ether group or ester group is preferred in terms of the effects described above.

The polar group may exist at any location within the alkyl groups X, Y, and Z. In other words, the polar group may exist as a terminal, or exist at a non-terminal position within an alkyl group. Furthermore, different polar groups or the same polar group may exist at two or more different positions. In those cases where a polar group exists at a terminal, the alkyl group becomes an alkylene group, and that alkylene group may also contain one or more polar groups. In the present invention, the alkyl groups X, Y, and Z also include this type of alkylene group.

Of the various possibilities, cases in which each of the alkyl groups X, Y, and Z contains at least one polar group are preferred. There are no particular restrictions on the upper limit for the number of polar groups, although the total number across the groups X, Y, and Z is typically no more than 10.

The alkyl groups X, Y, and Z may each be straight chain, branched chain or cyclic groups.

Furthermore, two terminals from the alkyl groups X, Y, and Z may also be bonded together to form a cyclic structure. In such cases, these two terminals form a cyclic alkylene group, and in the present invention, the alkyl groups X, Y, and Z also include this type of alkylene group.

The alkyl groups X, Y, and Z may include an aryl group bonded at a group terminal, and examples of this aryl groups include substituted and unsubstituted phenyl groups and naphthyl groups, although in terms of improving the transparency relative to the exposure light and achieving a high level of resolution, straight chain, branched chain, or cyclic alkyl groups that contain no aryl groups are preferred.

Furthermore, the number of carbon atoms within each of the alkyl groups X, Y, and Z, excluding any polar groups, is typically within a range from 1 to 20, and preferably from 3 to 10.

The number of carbon atoms in the alkyl groups X, Y, and Z may be the same for each group or different, but components in which the number of carbon atoms is the same for each group are preferred in terms of the stability of the effects.

Furthermore, the alkyl groups X, Y, and Z may have the same structure or different structures, although in terms of the stability of the effects achieved, at least 2 of the groups preferably have the same structure, and components in which all 3 groups have the same structure are the most preferred.

Specific examples of this type of component (D) include the compounds shown below.

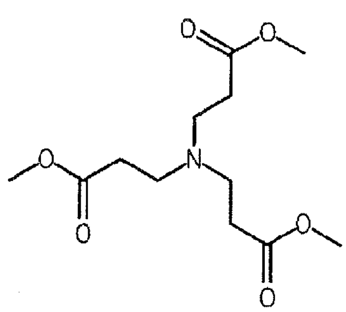
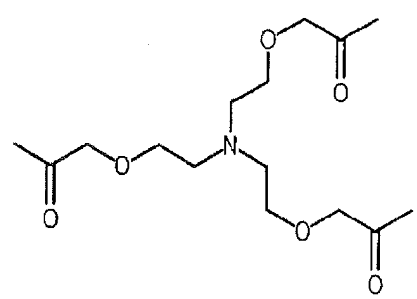

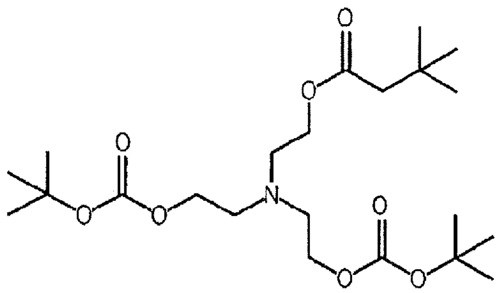

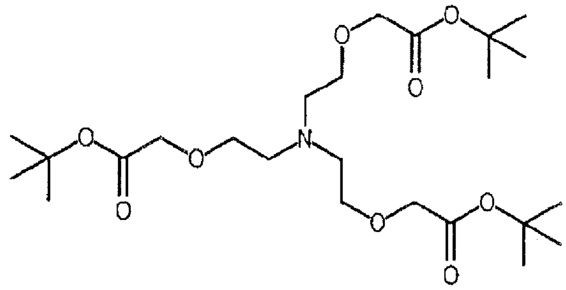

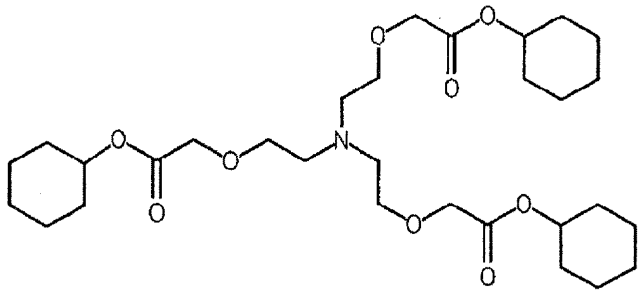

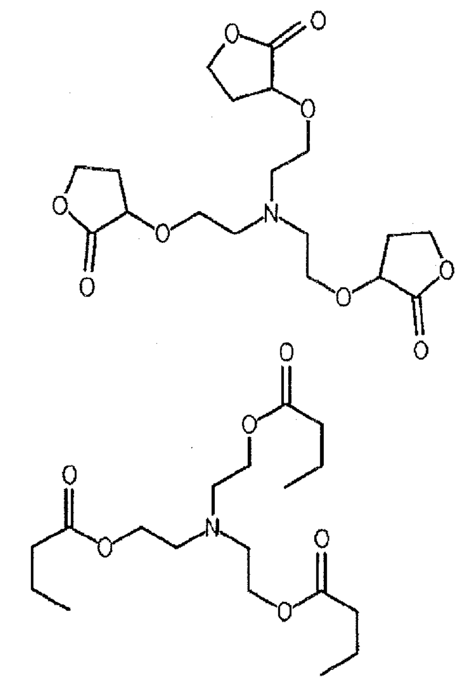

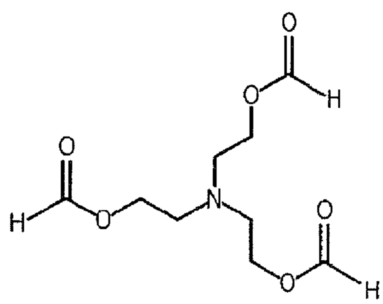

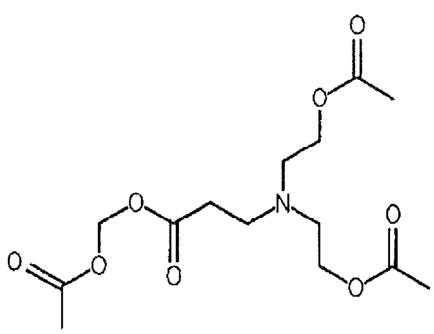

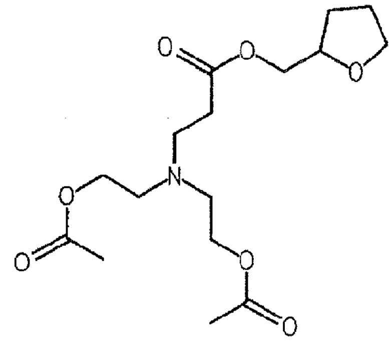

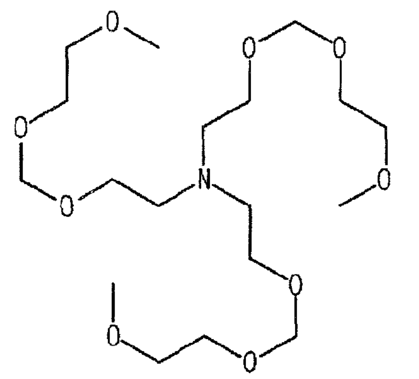

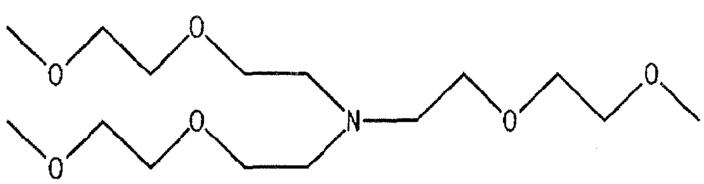

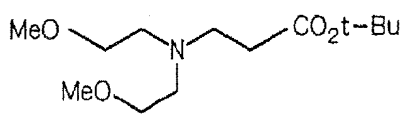

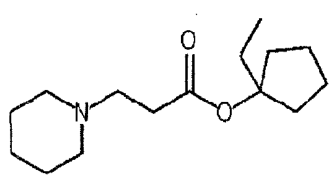

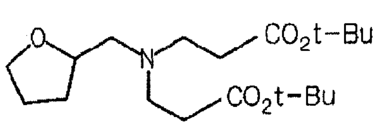

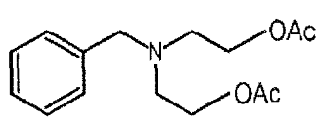

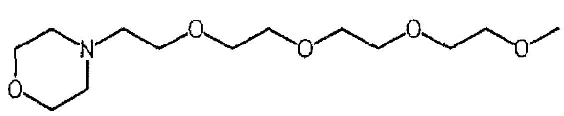

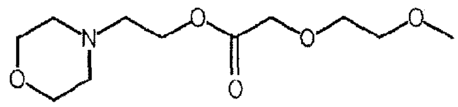

Preferred examples of the component (D) include the compounds shown below.

[Formula 4]

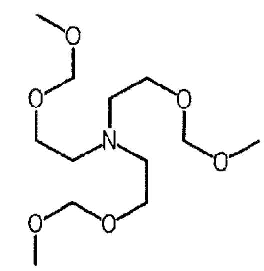

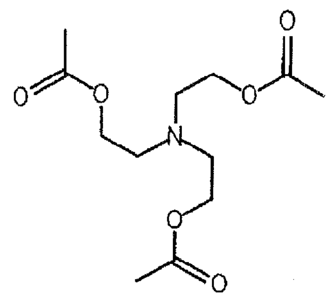

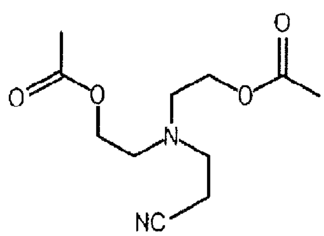

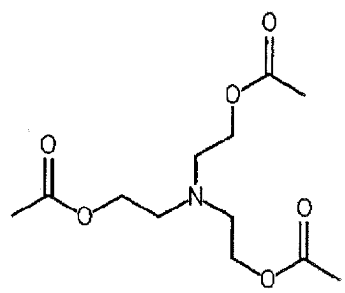

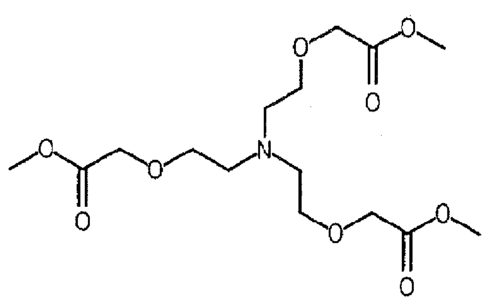

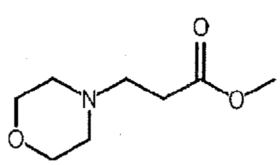

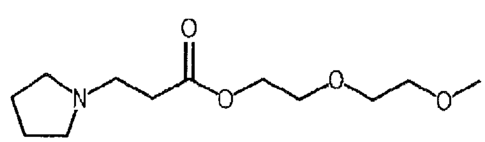

[Formula 5]

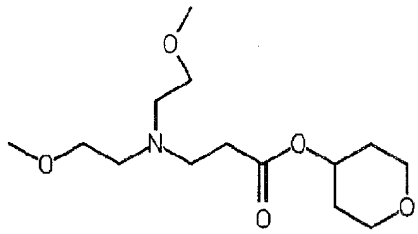

(N-1)

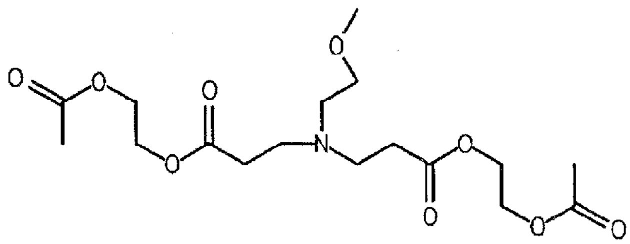

(N-2)

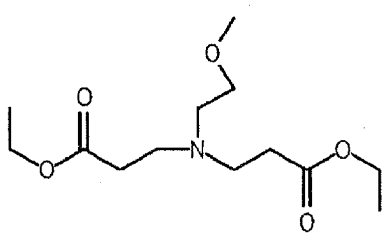

(N-3)

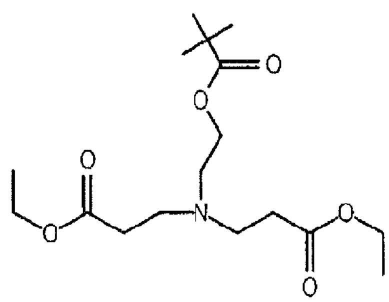

(N-4)

The most preferred forms of the component (D) are represented by a general formula (2) shown below.

[Formula 6]

$$N\{R^{11}-0-R^{12}-0-R^{13})_3 \quad (2)$$

(wherein, $R^{11}$ and $R^{12}$ each represent, independently, a lower alkylene group, and $R^{13}$ represents a lower alkyl group)

$R^{11}$, $R^{12}$, and $R^{13}$ may be straight chain, branched chain, or cyclic groups, although straight chain or branched chain groups are preferred.

From the viewpoint of regulating the molecular weight, the number of carbon atoms within each of the groups $R^{11}$, $R^{12}$, and $R^{13}$ is typically from 1 to 5, and preferably from 1 to 3. The number of carbon atoms within each of $R^{11}$, $R^{12}$, and $R^{13}$ may be either the same or different. The structures of $R^{11}$ and $R^{12}$ may be either the same or different.

Examples of compounds represented by the general formula (2) include tris-(2-methoxymethoxyethyl)amine and tris-2-(2-methoxy(ethoxy))ethylamine. Of these, tris-2-(2-methoxy(ethoxy))ethylamine is preferred. Examples of compounds other than those represented by the general formula (2) include tris-(2-(2-methoxyethoxy)methoxyethyl) amine.

The component (D) can use either a single compound, or a mixture of two or more different compounds.

The component (D) is typically used in a quantity equivalent to 0.01 to 2.0% by weight, and preferably from 0.03 to 1.0% by weight, relative to 100 parts by weight of the component (A). Using a quantity of at least 0.01 % by weight ensures that the effect of adding the component manifests satisfactorily, whereas using a quantity of no more than 2.0% by weight prevents any deterioration in the sensitivity.

The reason that using a component (D) with this type of specific structure enables characteristics that are suited to immersion lithography to be obtained remains unclear, but is thought to be as described below.

Namely, because the component (D) contains a polar group and has a large molecular weight, it is thought that during the heating within the prebake step used for forming the resist layer, the component (D) is dispersed uniformly within the resist layer. Furthermore, the solubility of the component in the type of solvents used for immersion lithography, and particularly in pure water, is comparatively low.

As a result, it is surmised that the component (D) is not concentrated near the surface of the resist layer that makes contact with the solvent, meaning unwanted effects such as the component (D) leaching into the solvent can be suppressed. Furthermore, it is also thought that by diffusing the component (D) uniformly within the resist layer, the diffusion of the acid generated from the aforementioned component (B) during post exposure baking (PEB) can be effectively suppressed, thereby contributing to improvements in the resolution and the resist pattern profile.

The inventors of the present invention developed the following standard as an indicator for determining whether or not a resist composition is suited to use within an immersion process.

Because a specific component (D) is used in a resist composition of the present invention, the composition is preferably capable of clearing this standard.

Namely, for a resist composition used in a method of forming a resist pattern that includes an immersion exposure step, if the sensitivity when a 1:1 line and space resist pattern of 130 nm is formed by a normal exposure lithography process using a light source with a wavelength of 193 nm is termed X1, and the sensitivity when an identical 1:1 line and space resist pattern of 130 nm is formed by a simulated immersion lithography process in which a step for bringing a solvent for the above immersion lithography in contact with the resist film is inserted between the selective exposure step and the post exposure baking (PEB) step of a normal exposure lithography process using a light source with the same wavelength of 193 nm is termed X2, then the absolute value of $[(X2/X1) - 1] \times 100$ is preferably no more than 8.0.

If the absolute value exceeds 8.0, then the resist composition becomes unsuitable for use in an immersion lithography process, and problems such as the resist pattern developing a T-top shape, or collapse of the resist pattern can arise.

Here, a normal exposure lithography process using a light source with a wavelength of 193 nm refers to a normal lithography process, namely, sequential steps for performing resist application, prebaking, selective exposure, post exposure baking, and alkali developing on top of a substrate such as a silicon wafer, which is conducted using an ArF excimer laser with a wavelength of 193 nm as the light source, by performing a normal exposure with the region between the exposure apparatus lens and the resist layer disposed on top of the wafer filled with air or an inert gas such as nitrogen. In some cases, a post bake step may also be provided following the alkali developing, and an organic or inorganic anti-reflective film may also be provided between the substrate and the applied layer of the resist composition.

The sensitivity X1 when a 130 nm 1:1 line and space resist pattern (hereafter abbreviated as "130 nm L&S")

is formed by this type of normal exposure lithography process is the exposure dose for forming a 130 nm L&S, which is widely used by those skilled in the art, and is self-explanatory.

To describe this sensitivity briefly for the sake of thoroughness, the exposure dose is placed along the horizontal axis, the resist line width formed using that exposure dose is placed on the vertical axis, and a logarithmic approximation curve is obtained from the plot using the method of least squares.

The formula is represented by $Y = aLoge(X1) + b$, wherein X1 represents the exposure dose, Y represents the resist line width, and a and b are constants. If this formula is rearranged and converted to a formula representing X1, the formula $X1 = Exp[(Y-b)/a]$ is obtained. If the value Y = 130 (nm) is introduced into this formula, then the calculated ideal sensitivity X1 can be determined.

The conditions during this process, namely the rotational speed during application of the resist, the prebake temperature, the exposure conditions, the post exposure baking conditions, and the alkali developing conditions can all be set to conventionally used conditions, and are self-evident for forming a 130 nm L&S. Specifically, a silicon wafer with a diameter of 8 inches is used as the substrate, the rotational speed is set to approximately 1000 to 4000 rpm, or more specifically to approximately 2000 rpm, and the prebake temperature is set within a range from 70 to 140°C, or more specifically to 115°C for a period of 90 seconds, and this enables a 6 inch diameter resist film with a film thickness of 80 to 250 nm, or more specifically of 200 nm, to be formed concentrically on top of the substrate.

The exposure conditions involve exposure through a mask, using an ArF excimer laser exposure apparatus with a wavelength of 193 nm manufactured by Nikon Corporation or Canon Inc. or the like (with NA = 0.60), or more specifically the exposure apparatus NSR-S302 (manufactured by Nikon Corporation, NA (numerical aperture) = 0.60, 2/3 annular illumination). A normal binary mask is used as the mask in the selective exposure. A phase shift mask may be used for this mask.

The post exposure baking uses a temperature within a range from 90 to 140°C, or more specifically 115°C for a period of 90 seconds, and the conditions for the alkali developing involve immersing the substrate in a 2.38% by weight developing solution of TMAH (tetramethylammonium hydroxide) at a temperature of 23 °C for a period of 15 to 90 seconds, or more specifically 60 seconds, and then rinsing the substrate with water.

Furthermore, the simulated immersion lithography process refers to a process in which a step for bringing an immersion exposure solvent in contact with the resist film is inserted between the selective exposure step and the post exposure baking (PEB) step of a normal exposure lithography process that uses the same 193 nm ArF excimer laser described above as the light source.

Specifically, the simulated process involves sequential steps for resist application, prebaking, selective exposure, a step for bringing the immersion exposure solvent in contact with the resist film, post exposure baking, and alkali developing. In some cases, a post bake step may also be provided following the alkali developing.

["Contact" may involve either immersing the selectively exposed resist film provided on the substrate in the immersion exposure solvent, or spraying the solvent onto the resist film in the form of a shower. The temperature during this step is set to 23°C, and the rotational speed of the substrate is set to a value within a range from 300 to 3000 rpm, and preferably from 500 to 2500 rpm.]

The conditions for the contact described above are as follows. Pure water is dripped onto the center of the substrate from a rinse nozzle, while the wafer and the attached exposed resist film are rotated; rotational speed of the substrate: 500 rpm; solvent: pure water; rate of dropwise addition of the solvent: 1.0 L/minute; solvent dripping time: 2 minutes; solvent and resist contact temperature: 23°C.

The sensitivity X2 when a 130 nm L&S resist pattern is formed using this type of simulated immersion lithography process is similar to the value of X1 described above in that it represents the exposure dose for forming a 130 nm L&S, which is a widely used value by those skilled in the art.

The conditions during this process (the rotational speed during application of the resist, the prebake temperature, the exposure conditions, the post exposure baking conditions, and the alkali developing conditions and the like) are also similar to the case of X1 described above. In other words, the conditions used for determining X2 are the same as those used for determining X1, with the exception of the step for bringing the immersion exposure solvent in contact with the resist film.

- Component (A)

The component (A) is a resin component that undergoes a change in alkali solubility under the action of acid.

As the component (A), one or more alkali soluble resins, or resins that can be converted to an alkali soluble state, which are typically used as the base resin for chemically amplified resists, can be used. The former describes a so-called negative resist composition, and the latter describes a positive resist composition. A resist composition of the present invention is preferably a positive composition.

In the case of a negative composition, a cross linking agent is added together with the acid generator component (B). Then, during resist pattern formation, when acid is generated from the acid generator component (B) by

exposure, the action of this acid causes cross linking between the alkali soluble resin component (A) and the cross linking agent, making the composition alkali insoluble. As the cross linking agent, a melamine containing a methylol group or alkoxymethyl group, urea, or an amino-based cross linking agent such as glycoluril or the like is used.

In the case of a positive composition, the resin component (A) is an alkali insoluble compound with a so-called acid dissociable, dissolution inhibiting group, and when acid is generated from the acid generator component (B) by exposure, this acid causes the acid dissociable, dissolution inhibiting group to dissociate, making the resin component (A) alkali soluble.

Regardless of whether the composition is positive or negative, the resin component (A) preferably does not contain any structural units (a0), including structural units (a0-1) containing an anhydride of a dicarboxylic acid, and structural units (a0-2) containing a phenolic hydroxyl group (hereafter referred to as either (a0) or (a0) units).

A structural unit (a0-1) containing an anhydride of a dicarboxylic acid refers to a structural unit containing a -C(O)-O-C(O)- structure. Examples of this type of unit include structural units containing either a monocyclic or polycyclic cyclic anhydride, and specific examples include units derived from the monocyclic and polycyclic maleic anhydrides shown below in [formula 7], and units derived from the itaconic acid shown below in [formula 8].

[formula 7]

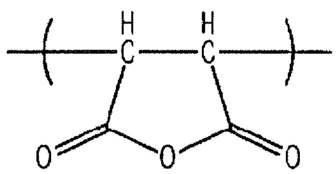
,
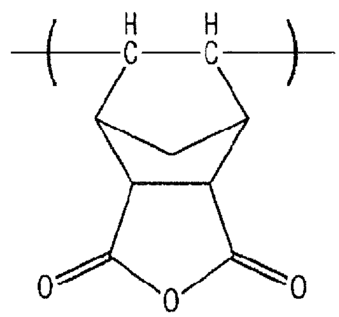

[formula 8]

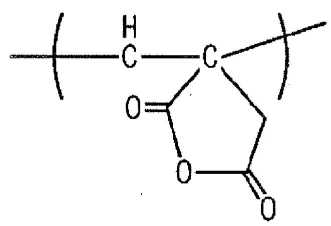

Furthermore, a structural unit (a0-2) containing a phenolic hydroxyl group refers to a structural unit containing a group with at least one hydroxyl group bonded to an aromatic hydrocarbon ring such as a benzene or naphthalene ring. Examples of this type of unit include hydroxystyrene units and (α-methyl)hydroxystyrene units. By ensuring that the component (A) does not contain (a0) units, namely (a0-1) and (a0-2) units, a composition that is resistant to solvent effects is obtained, and a resist pattern with excellent sensitivity and resist pattern profile can be formed, even in an immersion exposure (immersion lithography) process.

Furthermore, regardless of whether the composition is positive or negative, the component (A) preferably contains structural units derived from (meth)acrylate esters.

In terms of improving the resolution and achieving characteristics that are most suited to applications in which

exposure is conducted using an ArF excimer laser, the component (A) preferably incorporates at least 80 mol%, and even more preferably at least 90 mol% (and most preferably 100 mol%) of structural units derived from (meth)acrylate esters.

Furthermore, in order to obtain a photoresist composition that exhibits minimal surface roughness on etching and minimal line edge roughness, superior resolution, and a broad depth of focus, the structural units derived from (meth)acrylate esters contained within the component (A) preferably include both structural units derived from methacrylate esters and structural units derived from acrylate esters.

Surface roughness on etching is different from the aforementioned resist pattern surface roughness (deterioration in the resist pattern profile) caused by the effects of the solvent, or conventional dry etching resistance, and appears on etched resist patterns following developing and formation of the resist pattern, either as distortions around the hole patterns in a contact hole pattern or as line edge roughness in a line and space pattern.

Line edge roughness occurs in resist patterns following developing. Line edge roughness appears as distortions around the hole patterns in a hole resist pattern or as nonuniform irregularities in the side surfaces in a line and space pattern.

Furthermore as described above, cutting edge technology continues to demand ever finer resolutions, in the vicinity of 90 nm, the vicinity of 65 nm, the vicinity of 45 nm, and even narrower resolutions, and it is envisaged that immersion lithography will be able to provide these types of resolution improvements.

In addition, broadening the depth of focus characteristics is also desirable.

In the component (A), by incorporating both structural units derived from methacrylate esters and structural units derived from acrylate esters, these types of characteristics can be improved.

Furthermore, by incorporating two types of structural units, a defect reduction effect can also be achieved. In this description, the term defect refers to general problems such as scum and resist pattern irregularities detected by inspecting the developed resist pattern from directly overhead using a surface defect inspection apparatus manufactured by KLA Tencor Corporation (brand name "KLA").

In this case, there are no particular restrictions on the form of the component (A) provided it incorporates structural units derived from methacrylate esters and structural units derived from acrylate esters, and suitable forms for the component (A) include: a copolymer (A1) in which the composition includes a copolymer containing structural units derived from a methacrylate ester and structural units derived from an acrylate ester; and a mixed resin (A2) in which the composition includes a mixed resin of a polymer containing at least structural units derived from a methacrylate ester, and a polymer containing at least structural units derived from an acrylate ester. Either one, or both of the polymers which constitute this mixed resin (A2) may be an aforementioned copolymer (A1).

The component (A) may also contain other resin components, although components formed from an aforementioned copolymer (A1) and/or a mixed resin (A2) are preferred.

The copolymer (A1) and the mixed resin (A2) may each also use combinations of two or more different materials.

The relative quantities of the structural units derived from methacrylate esters and structural units derived from acrylate esters within the component (A) are preferably adjusted so that relative to the total number of mols of structural units derived from methacrylate esters and acrylate esters, the structural units derived from methacrylate esters account for 10 to 85 mol%, and preferably from 20 to 80 mol%, and the structural units derived from acrylate esters account for 15 to 90 mol%, and preferably from 20 to 80 mol%.

If the quantity of structural units derived from methacrylate esters is too high then the surface roughness improvement effect diminishes, whereas if the quantity of structural units derived from acrylate esters is too high then there is a danger of a decrease in resolution.

Furthermore, in the case of a positive composition, the component (A) preferably contains a structural unit (a1) derived from a (meth)acrylate ester containing an acid dissociable, dissolution inhibiting group.

As follows is a description of the case of a positive composition.

In order to ensure satisfactory resolution, dry etching resistance, and an ultra fine pattern shape, the component (A) preferably comprises a plurality of monomer units with different functions in addition to the (a1) units, such as a combination with at least one of the structural units described below.

Structural units derived from a (meth)acrylate ester containing a lactone unit (hereafter referred to as either (a2) or (a2) units).

Structural units derived from a (meth)acrylate ester containing a polycyclic group with an alcoholic hydroxyl group (hereafter referred to as either (a3) or (a3) units).

Structural units containing a polycyclic group that differs from the acid dissociable, dissolution inhibiting group of the (a1) units, the lactone unit of the (a2) units and the polycyclic group with an alcoholic hydroxyl group of the (a3) units (hereafter referred to as either (a4) or (a4) units).

The (a2), (a3) and/or (a4) units can be combined appropriately to achieve the desired characteristics.

The component (A) preferably comprises (a1) and (a2) units, as this improves the resistance to dissolution

in the solvent used in the immersion lithography process, and produces a favorable resolution and resist pattern shape. In addition, these two structural units preferably account for at least 40 mol%, and even more preferably at least 60 mol% of the component (A).

Each of the units (a1) to (a4) may also include a combination of a plurality of different units.

As follows is a more detailed description of the units (a1) to (a4) mentioned above. [(a1) Units]

An (a1) unit is a structural unit derived from a (meth)acrylate ester containing an acid dissociable, dissolution inhibiting group.

There are no particular restrictions on the acid dissociable, dissolution inhibiting group of the structural unit (a1), provided it exhibits an alkali dissolution inhibiting effect that causes the entire component (A) to be alkali insoluble prior to exposure, but then dissociates under the action of acid generated from the aforementioned component (B) following exposure, causing the entire component (A) to become alkali soluble. Generally, groups which form a cyclic or chain-like tertiary alkyl ester at the carboxyl group of (meth)acrylic acid, tertiary alkoxycarbonyl groups, or chain-like alkoxyalkyl groups are the most widely used.

As the acid dissociable, dissolution inhibiting group of (a1), an acid dissociable, dissolution inhibiting group containing an aliphatic polycyclic group can be favorably used.

Examples of this polycyclic group include groups in which one hydrogen atom has been removed from a bicycloalkane, a tricycloalkane or a tetracycloalkane or the like which is either unsubstituted or substituted with a fluorine atom or a fluorinated alkyl group. Specific examples include groups in which one hydrogen atom has been removed from a polycycloalkane such as adamantane, norbornane, isobornane, tricyclodecane or tetracyclododecane. These types of polycyclic group can be appropriately selected from the multitude of groups proposed for use with ArF resists. Of these groups, adamantyl groups, norbornyl groups and tetracyclododecanyl groups are preferred industrially.

Ideal monomer units for (a1) are shown below in [formula 9] to [formula 17].

[formula 9]

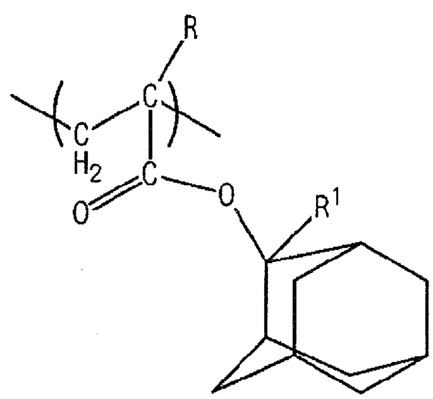

···(I)

(wherein, R represents a hydrogen atom or a methyl group, and $R^1$ represents a lower alkyl group)

[formula 10]

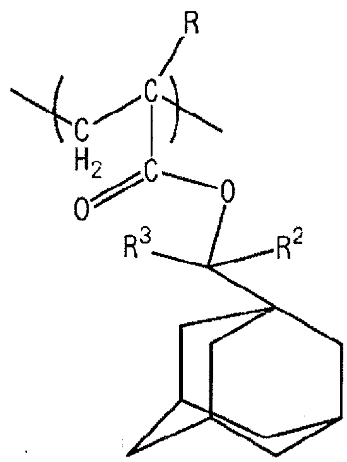

···(II)

(wherein, R represents a hydrogen atom or a methyl group, and $R^2$ and $R^3$ each represent, independently, a lower alkyl group)

[formula 11]

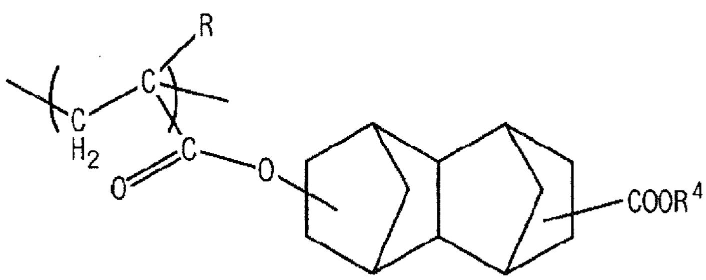

···(III)

(wherein, R represents a hydrogen atom or a methyl group, and $R^4$ represents a tertiary alkyl group)

[formula 12]

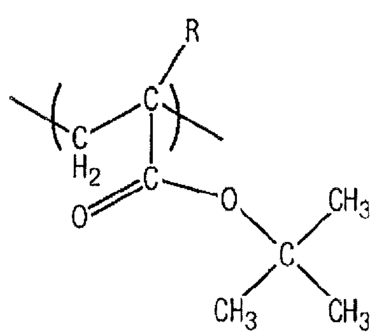

(wherein, R represents a hydrogen atom or a methyl group)

[formula 13]

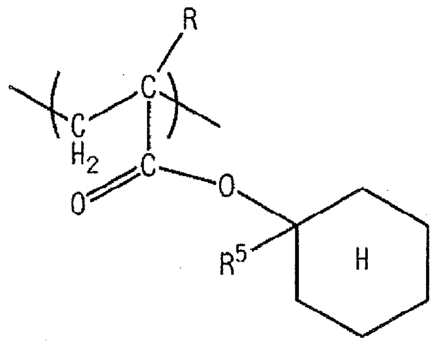

(wherein, R represents a hydrogen atom or a methyl group, and $R^5$ represents a methyl group)

[formula 14]

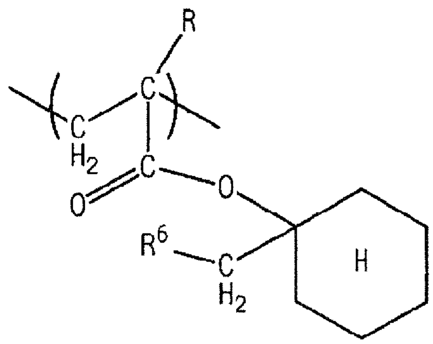

(wherein, R represents a hydrogen atom or a methyl group, and $R^6$ represents a lower alkyl group)

[formula 15]

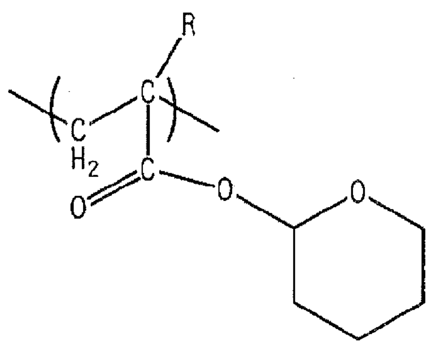

(wherein, R represents a hydrogen atom or a methyl group)

[formula 16]

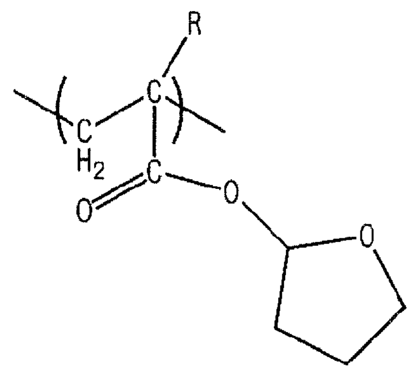

(wherein, R represents a hydrogen atom or a methyl group)

[formula 17]

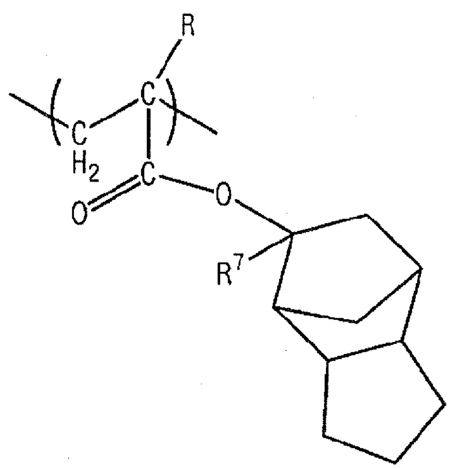

(wherein, R represents a hydrogen atom or a methyl group, and $R^7$ represents a lower alkyl group)

Within the above formulas, the groups $R^1$ to $R^3$ and $R^6$ to $R^7$ each preferably represent a straight chain or branched alkyl group of 1 to 5 carbon atoms, and specific examples include a methyl group, ethyl group, propyl group, isopropyl group, n-butyl group, isobutyl group, tert-butyl group, pentyl group, isopentyl group and neopentyl group. From an industrial viewpoint, a methyl group or ethyl group is preferred.

Furthermore, $R^4$ represents a tertiary alkyl group such as a tert-butyl group or tert-amyl group, although a tert-butyl group is preferred industrially.

As the (a1) unit, of all the units described above, structural units represented by the general formulas (I), (II) and (III) exhibit particularly superior resistance to dissolution in the solvents used in immersion lithography processes, and are capable of forming patterns with excellent resolution, and are consequently the most preferred.

[(a2) Units]

An (a2) unit contains a lactone unit, and is consequently effective in increasing the adhesion between the resist film and the substrate, and improving the hydrophilicity with the developing liquid, and also displays excellent resistance to dissolution in the solvents used in immersion lithography processes.

An (a2) unit of the present invention may be any unit which contains a lactone unit and is copolymerizable with the other structural units of the component (A).

Examples of monocyclic lactone units include groups in which one hydrogen atom has been removed from γ-butyrolactone. Furthermore, examples of polycyclic lactones include groups in which one hydrogen atom has been removed from a polycycloalkane containing a lactone. In the lactone unit, the ring containing the -O-C(O)- structure is counted as the first ring. Accordingly, the case in which the only ring structure is the ring containing the -O-C(O)- structure is referred to as a monocyclic group, and groups containing other ring structures are described as polycyclic groups regardless of the structure of the other rings.

Ideal monomer units for (a2) are shown below in [formula 18] to [formula 20].

[formula 18]

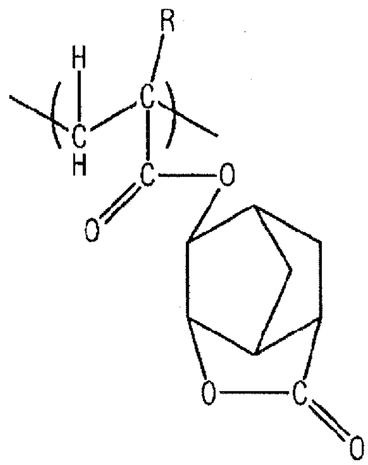

(wherein, R represents a hydrogen atom or a methyl group)

[formula 19]

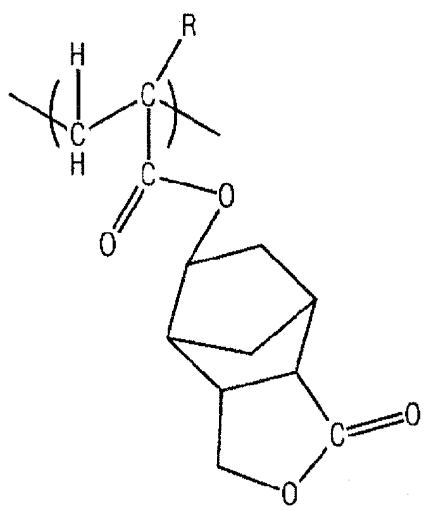

(wherein, R represents a hydrogen atom or a methyl group)

[formula 20]

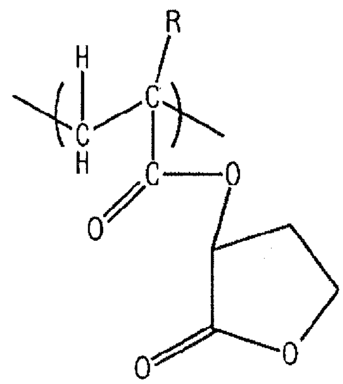

(wherein, R represents a hydrogen atom or a methyl group)

Of the above structural units, γ-butyrolactone esters of (meth)acrylic acid with an ester linkage at the α carbon atom such as those shown in [formula 20], or norbornane lactone esters such as those shown in [formula 18] and [formula 19] are particularly preferred in terms of industrial availability.

[(a3) Units]

An (a3) unit is a structural unit derived from a (meth)acrylate ester containing a polycyclic group with an alcoholic hydroxyl group.

Because the hydroxyl group of the alcoholic hydroxyl group-containing polycyclic group is a polar group, use of the structural unit (a3) results in an increased hydrophilicity for the entire component (A) relative to the developing liquid, and an improvement in the alkali solubility of the exposed sections of the resist, while also providing excellent resistance to dissolution in the solvents used in immersion lithography processes. Accordingly, if the component (A) contains (a3) units, then the resolution improves favorably.

As the polycyclic group in the (a3) unit, an aliphatic polycyclic group can be appropriately selected from the various polycyclic groups listed in the above description for the structural unit (a1).

There are no particular restrictions on the alcoholic hydroxyl group-containing polycyclic group within the unit (a3), and for example, hydroxyl group-containing adamantyl groups can be favorably used.

In addition, if this hydroxyl group-containing adamantyl group is a group represented by a general formula (IV) shown below, then the dry etching resistance improves, as does the verticalness of the cross-sectional shape of the pattern, both of which are desirable.

[formula 21]

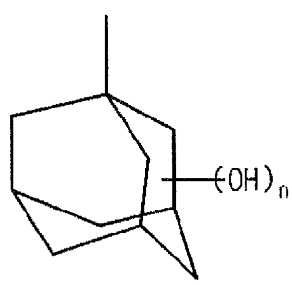

· · · (IV)

(wherein, n represents an integer from 1 to 3)

The (a3) unit may be any unit which contains an aforementioned alcoholic hydroxyl group-containing polycyclic group and is copolymerizable with the other structural units of the component (A).

Specifically, structural units represented by a general formula (V) shown below are preferred.

[formula 22]

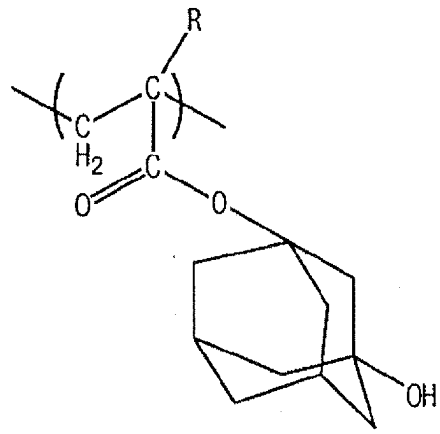

···(V)

(wherein, R represents a hydrogen atom or a methyl group)

[(a4) Units]

In a unit (a4), a polycyclic group which "differs from the aforementioned acid dissociable, dissolution inhibiting groups, the aforementioned lactone units and the aforementioned alcoholic hydroxyl group-containing polycyclic groups" means that in the component (A), the polycyclic group of the unit (a4) is a polycyclic group which does not duplicate the acid dissociable, dissolution inhibiting group of the (a1) units, the lactone unit of the (a2) units, or the alcoholic hydroxyl group-containing polycyclic group of the (a3) units, and also means that the (a4) unit does not support the acid dissociable, dissolution inhibiting group of the (a1) units, the lactone unit of the (a2) units, or the alcoholic hydroxyl group containing polycyclic group of the (a3) units, which constitute the component (A).

There are no particular restrictions on the polycyclic group of the (a4) unit, provided it is selected so as not to duplicate any of the structural units used as the units (a1) to (a3). For example, as the polycyclic group in the (a4) unit, similar aliphatic polycyclic groups to those listed in the above description for the structural unit (a1) can be used, and any of the multitude of materials conventionally used for ArF positive resist materials can be used.

From the viewpoint of industrial availability, one or more groups selected from amongst tricyclodecanyl groups, adamantyl groups, and tetracyclododecanyl groups is preferred.

The (a4) unit may be any unit which contains this type of polycyclic group and is copolymerizable with the other structural units of the component (A).

Preferred examples of (a4) units are shown below in [formula 23] to [formula 25].

[formula 23]

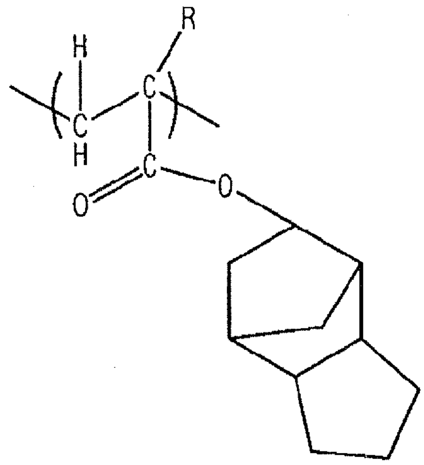

(wherein, R represents a hydrogen atom or a methyl group)

[formula 24]

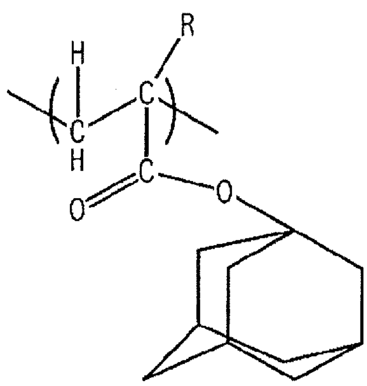

(wherein, R represents a hydrogen atom or a methyl group)

[formula 25]

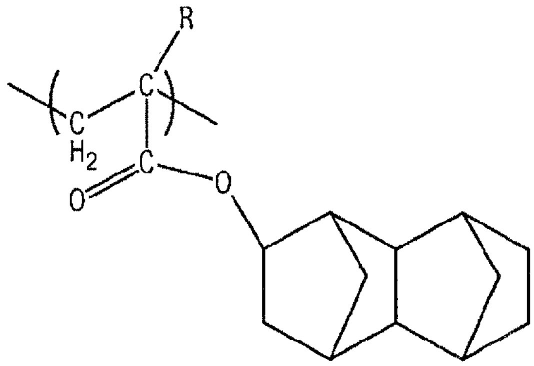

(wherein, R represents a hydrogen atom or a methyl group)

In a resist composition of the present invention, component (A) compositions in which the (a1) units account for 20 to 60 mol%, and preferably from 30 to 50 mol%, of the combined total of all the structural units of the component (A) display excellent resolution, and are consequently preferred.

Furthermore, compositions in which the (a2) units account for 20 to 60 mol%, and preferably from 30 to 50 mol%, of the combined total of all the structural units of the component (A) display excellent resolution and adhesion, and are consequently preferred.

Furthermore, in those cases where (a3) units are used, compositions in which the (a3) units account for 5 to 50 mol%, and preferably from 10 to 40 mol%, of the combined total of all the structural units of the component (A) display excellent resist pattern shape, and are consequently preferred.

In those cases where (a4) units are used, compositions in which the (a4) units account for 1 to 30 mol%, and preferably from 5 to 20 mol%, of the combined total of all the structural units of the component (A) offer superior resolution for isolated patterns through to semi-dense patterns, and are consequently preferred.

Furthermore, in the present invention, a resin component of a resist for a $F_2$ excimer laser can also be favorably used, provided it contains the aforementioned (a1) units and contains no (a0) units. This type of $F_2$ resist resin component is a copolymer that contains a unit with a group that contains a fluorine atom or a fluoroalkyl group on the side chain of a (meth)acrylate ester unit.

Furthermore, there are no particular restrictions on the weight average molecular weight (the polystyrene equivalent value, this also applies to subsequent molecular weight values) of the resin component (A) of the present invention, although values are typically within a range from 5,000 to 30,000, and preferably from 8,000 to 20,000. If the molecular weight is greater than this range, then the solubility of the component in the resist solvent deteriorates, whereas if the molecular weight is too small, there is a danger of a deterioration in the dry etching resistance or the cross sectional shape of the resist pattern.

The resin component (A) of the present invention can be produced easily by a conventional radical polymerization of a monomer corresponding with the structural unit (a1), and where required, monomers corresponding with each of the structural units (a2), (a3) and/or (a4), using a radical polymerization initiator such as azobisisobutyronitrile (AIBN).

- Acid Generator Component (B)

In the present invention, as the acid generator component (B), a compound appropriately selected from known materials used as acid generators in conventional chemically amplified resists can be used.

Of these possible acid generators, onium salts with a fluorinated alkylsulfonate ion as the anion are preferred. Examples of preferred acid generators include onium salts such as diphenyliodonium trifluoromethanesulfonate, (4-methoxyphenyl)phenyliodonium trifluoromethanesulfonate, bis(p-tert-butylphenyl)iodonium trifluoromethanesulfonate, triphenylsulfonium trifluoromethanesulfonate, (4-methoxyphenyl)diphenylsulfonium trifluoromethanesulfonate, (4-methylphenyl)diphenylsulfonium nonafluorobutanesulfonate, (p-tert-butylphenyl)diphenylsulfonium trifluoromethanesulfonate, diphenyliodonium nonafluorobutanesulfonate, bis(p-tert-butylphenyl)iodonium nonafluorobutanesulfonate, triphenylsulfonium nonafluorobutanesulfonate, (4-trifluoromethylphenyl)diphenylsulfonium trifluoromethanesulfonate, (4-trifluoromethylphenyl)diphenylsulfonium nonafluorobutanesulfonate, and tri(p-tert-butylphenyl)sulfonium trifluoromethanesulfonate.

As this component (B), either a single acid generator may be used alone, or a combination of two or more acid generators may be used.

The quantity of the component (B) is typically within a range from 0.5 to 30 parts by weight, and preferably from 1 to 10 parts by weight, per 100 parts by weight of the component (A). At quantities less than 0.5 parts by weight, pattern formation does not proceed satisfactorily, whereas if the quantity exceeds 30 parts by weight, achieving a uniform solution becomes difficult, and there is a danger of a deterioration in the storage stability.

- Organic Solvent (C)

A photoresist composition according to the present invention can be produced by dissolving the aforementioned component (A) and the aforementioned component (B), together with an optional component (D) and/or component (E) described below, in an organic solvent (C).

The organic solvent (C) may be any solvent capable of dissolving the aforementioned component (A) and the aforementioned component (B) to generate a uniform solution, and one or more solvents selected from known materials used as the solvents for conventional chemically amplified resists can be used.

Specific examples of the organic solvent (C) include ketones such as γ-butyrolactone, acetone, methyl ethyl ketone, cyclohexanone, methyl isoamyl ketone and 2-heptanone; polyhydric alcohols and derivatives thereof such as ethylene glycol, ethylene glycol monoacetate, diethylene glycol, diethylene glycol monoacetate, propylene glycol, propylene glycol monoacetate, dipropylene glycol, or the monomethyl ether, monoethyl ether, monopropyl ether, monobutyl ether or monophenyl ether of dipropylene glycol monoacetate; cyclic ethers such as dioxane; and esters such as methyl lactate, ethyl lactate, methyl acetate, ethyl acetate, butyl acetate, methyl pyruvate, ethyl pyruvate, methyl methoxypropionate, and ethyl ethoxypropionate. These organic solvents can be used alone, or as a mixed solvent of two or more different solvents.

In particular, mixed solvents of propylene glycol monomethyl ether acetate (PGMEA), and a polar solvent containing a hydroxyl group or a lactone such as propylene glycol monomethyl ether (PGME), ethyl lactate (EL) or γ-butyrolactone offer improved storage stability for photoresist compositions, and are consequently preferred. In cases in which EL is mixed with PGMEA, the weight ratio of PGMEA:EL is preferably within a range from 6:4 to 4:6.

In case where PGME is mixed with PGMEA, the weight ratio of PGMEA:PGME is typically within a range from 8:2 to 2:8, and preferably from 8:2 to 5:5.

In a photoresist composition according to the present invention, the quantity of the organic solvent (C) is selected so that the solid fraction concentration for the resist composition is within a range from 3 to 30% by weight, and the actual quantity is set in accordance with the film thickness of the resist.

- Other components

In a photoresist composition according to the present invention, where required, other nitrogen-containing organic compounds may also be added in addition to the component (D).

In addition, an organic carboxylic acid, or a phosphorus oxo acid or derivative thereof can also be added as an optional component (E). Either one, or both of the component (D) and the component (E) can be used.

Examples of suitable organic carboxylic acids include malonic acid, citric acid, malic acid, succinic acid, benzoic acid, and salicylic acid.

Examples of suitable phosphorus oxo acids or derivatives thereof include phosphoric acid or derivatives thereof such as esters, including phosphoric acid, di-n-butyl phosphate and diphenyl phosphate; phosphonic acid or derivatives thereof such as esters, including phosphonic acid, dimethyl phosphonate, di-n-butyl phosphonate, phenylphosphonic acid, diphenyl phosphonate and dibenzyl phosphonate; and phosphinic acid or derivatives thereof such as esters, including phosphinic acid and phenylphosphinic acid, and of these, phosphonic acid is particularly preferred.

The component (E) is typically used in a quantity within a range from 0.01 to 5.0 parts by weight per 100 parts by weight of the component (A).

Miscible additives can also be added to a photoresist composition according to the present invention according to need, and examples include additive resins for improving the properties of the resist film, surfactants for improving the ease of application, dissolution inhibitors, plasticizers, stabilizers, colorants and halation prevention agents.

Production of a photoresist composition of the present invention can be conducted by simply mixing and stirring each of the components together using conventional methods, and where required, the composition may also be mixed and dispersed using a dispersion device such as a dissolver, homogenizer, or triple roll mill. Furthermore, following mixing, the composition may also be filtered using a mesh or a membrane filter or the like.

[Pattern Formation Method]

Next is a description of a method of forming a resist pattern according to the present invention.
First, a photoresist composition according to the present invention is applied to the top of a substrate such as a silicon wafer using a spinner or the like, and a prebake (PAB treatment) is then performed.
An organic or inorganic anti-reflective film may also be provided between the substrate and the applied layer of the resist composition, creating a 2-layer laminate.
Furthermore, a 2-layer laminate in which an organic anti-reflective film is provided on top of the applied layer of the resist composition can also be formed, and a 3-layer laminate comprising an additional bottom layer anti-reflective film can also be formed.
The steps up until this point can be conducted using conventional techniques. The operating conditions are preferably set in accordance with the makeup and the characteristics of the photoresist composition being used.
Subsequently, the resist layer formed from the applied film of the photoresist composition is subjected to selective liquid immersion lithography through a desired mask pattern. At this time, the region between the resist layer and the lens at the lowermost point of the exposure apparatus is filled with a solvent that has a larger refractive index than the refractive index of air, and the exposure is preferably conducted with this region filled with a solvent with a refractive index that is larger than the refractive index of air but smaller than the refractive index of the resist layer.
There are no particular restrictions on the wavelength used for the exposure, and an ArF excimer laser, KrF excimer laser, $F_2$ excimer laser, or other radiation such as EUV (extreme ultraviolet), VUV (vacuum ultraviolet), electron beam, X-ray or soft X-ray radiation can be used. A photoresist composition according to the present invention is particularly effective for ArF excimer lasers.
As described above, in a method of forming a resist pattern according to the present invention, during exposure, the region between the resist layer and the lens at the lowermost point of the exposure apparatus is preferably filled with a solvent with a refractive index that is larger than the refractive index of air.
Examples of this solvent with a refractive index that is larger than the refractive index of air include water, and fluorine-based inert liquids. Specific examples of these fluorine-based inert liquids include liquids containing a fluorine-based compound such as $C_3HCl_2F_5$, $C_4F_9OCH_3$, $C_4F_9OC_2H_5$ and $C_5H_3F_7$ as the primary component. A photoresist composition of the present invention is particularly resistant to any deleterious effects caused by water, and exhibits minimal line edge roughness and excellent resist pattern shape. Furthermore, water is preferred in terms of cost, safety, environmental friendliness and flexibility.
Furthermore, there are no particular restrictions on the refractive index of the solvent with a refractive index that is larger than the refractive index of air, provided the refractive index falls within this specified range.
Subsequently, following completion of the exposure step, PEB (post exposure baking) is conducted, and then developing is performed using an alkali developing liquid comprising an aqueous alkali solution. The substrate is then preferably rinsed with pure water. This water rinse is conducted, for example, by dripping or spraying water onto the surface of the substrate while it is rotated, and washes away the developing solution and those sections of the resist composition that have been dissolved by the developing solution, removing them from the surface of the substrate. By conducting a subsequent drying treatment, the film of the photoresist composition is patterned into a shape corresponding with the mask pattern.
By forming a resist pattern in this manner, a resist pattern with an ultra fine line width, and in particular a line and space (L&S) pattern with a small pitch, can be produced with good resolution and a favorable resist pattern profile.
In this description, the pitch of a line and space pattern is the combined distance of a resist pattern width and a space width in a direction across the width of the pattern lines.

EXAMPLES

As follows is a description of examples of the present invention, although the scope of the present invention is in no way limited by these examples.
In the examples described below, unless otherwise stated, the conditions for the simulated immersion lithography and the sensitivity measurements were as follows.

(1) Conditions for Forming the Applied Resist Film
Substrate: 8 inch silicon wafer;
Resist application method: application using a spinner onto a substrate rotating at 2000 rpm;
Size of the applied resist film: diameter of 6 inches, concentric with the substrate, thickness 200 nm;
Prebake conditions: 115°C, 90 seconds;
Selective exposure conditions: exposure conducted using an ArF excimer laser (193 nm) (exposure apparatus NSR-S302B, manufactured by Nikon Corporation, NA (numerical aperture) = 0.60, 2/3 annular illumination).

(2) Conditions for Contact between Applied Resist Film and Solvent

Rotational speed of substrate: 500 rpm;
Solvent: water;
Solvent dripping rate: 1.0 L/minute
Solvent dripping time: 2 minutes
Temperature of contact between solvent and resist: 23°C.

(3) Conditions for Forming the Resist Pattern

Post exposure baking conditions: 115°C, 90 seconds;
Alkali developing conditions: 60 seconds developing at 23°C in a 2.38% by weight aqueous solution of tetramethylammonium hydroxide.

[Example 1]

- Evaluation of resist pattern profiles in line and space patterns with line widths of 90 nm and 65 nm

A component (A), a component (B), and a component (D) described below were dissolved uniformly in a component (C), yielding a photoresist composition 1.

As the component (A), 100 parts by weight of a methacrylate-acrylate copolymer comprising the three structural units shown in the [formula 26] was used. The proportions p, q and r of each of the structural units used in preparing the component (A) were p = 50 mol%, q = 30 mol%, and r = 20 mol% respectively. This copolymer contained no structural units containing an anhydride of a dicarboxylic acid, and no structural units containing a phenolic hydroxyl group. The weight average molecular weight of the thus prepared component (A) was 10,000.

[formula 26]

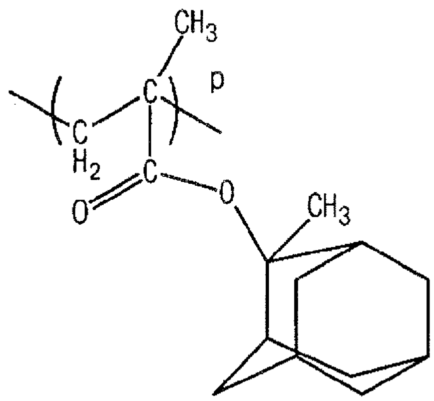

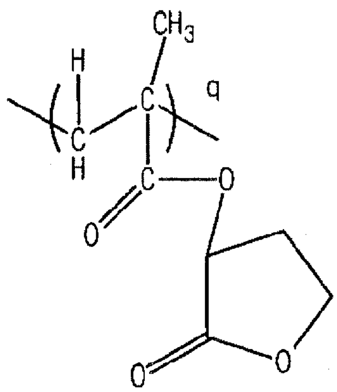

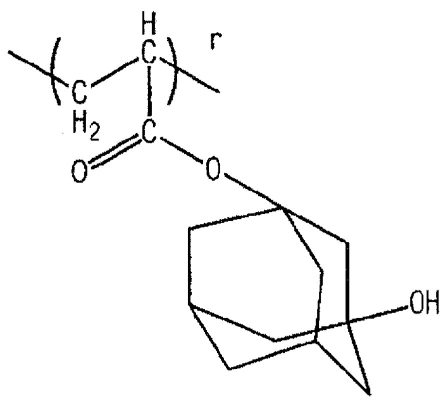

As the component (B), 3.5 parts by weight of triphenylsulfonium nonafluorobutanesulfonate and 1.0 parts by weight of (4-methylphenyl)diphenylsulfonium trifluoromethanesulfonate were used.
As the component (C), 1900 parts by weight of a mixed solvent of propylene glycol monomethyl ether acetate and ethyl lactate (weight ratio 6:4) was used.
As the component (D), 0.65 parts by weight of tris-2-(2-methoxy(ethoxy))ethylamine was used.
Next, using the thus obtained resist composition 1, a resist pattern was formed.

First, an organic anti-reflective film composition AR-19 (manufactured by Shipley Co., Ltd.) was applied to the surface of a silicon wafer using a spinner, and was then baked and dried at 215°C for 60 seconds on a hotplate, thereby forming an anti-reflective film layer with a film thickness of 82 nm. The photoresist composition 1 obtained above was applied to the top of the anti-reflective film using a spinner, and was then prebaked and dried on a hotplate at 115°C for 90 seconds, forming a resist layer with a film thickness of 140 nm on top of the anti-reflective film.

Immersion exposure was then conducted with a test apparatus manufactured by Nikon Corporation, by carrying out a test using a prism, water, and the interference of two beams of 193 nm. The same method is disclosed in the aforementioned non-patent reference 2, and this method is widely known as a simple method of obtaining a L&S pattern at the laboratory level.

In this immersion exposure, a water solvent layer was formed between the resist layer and the lower surface of the prism.

The exposure dose was selected so as to allow stable formation of a L&S pattern.

A PEB treatment was then performed at 115°C for 90 seconds, and the resist layer was then developed for 60 seconds in an alkali developing liquid at 23°C. As the alkali developing liquid, a 2.38% by weight aqueous solution of tetramethylammonium hydroxide was used.

This test is used for investigating the effect of the water solvent layer on the resist layer, as well as the resolution of the resist pattern and the pattern profile and the like. Accordingly, if the results of the test are either similar or superior to those obtained for the comparative example 2, which uses air, then this indicates that resolution of that resist layer is possible without the water solvent having any effect on the resist layer, and that if immersion lithography is used, then an improvement in the resolution and a broader depth of focus can be realized, enabling the production of an ultra fine pattern.

Following the test, the line width and pitch were measured. Furthermore, the resist pattern shape was inspected using a SEM.

The results are shown in Table 1.

[Comparative Example 1]

With the exception of altering the component (D) to 0.3 parts by weight of triethanolamine, operations were conduced in the same manner as the example 1.

The results are shown in Table 1.

[Comparative Example 2]

With the exception of bringing the prism and the resist layer into direct contact, without using any water, operations were conduced in the same manner as the example 1.

The results are shown in Table 1.

[Comparative Examples 3, 4, 5, and 6]

With the exceptions of altering the component (D), to 0.7 parts by weight of tri-n-octylamine (Mw: 353) in the comparative example 3, to 0.49 parts by weight of triphenylamine (Mw: 245) in the comparative example 4, to 0.2 parts by weight of triethylamine (Mw: 101) in the comparative example 6, and to 0.38 parts by weight of triisopopanolamine (Mw: 191) in the comparative example 5, resist compositions were prepared in the same manner as the example 1, and with the exception of then altering the immersion exposure to normal exposure, resist patterns were formed in the same manner as the example 1, but the resulting resist patterns were inferior to that obtained by normal exposure using triethanolamine in the comparative example 1, and the resolution was also poor.

[Table 1]

| | Example 1 | | Comparative example 1 | | Comparative example 2 |
|---|---|---|---|---|---|
| Solvent | Water | | Water | | Air |
| Target line width (nm) | 90.0 | 65.0 | 90.0 | 65.0 | 90.0 |
| Target pitch (nm) | 180.0 | 130.0 | 180.0 | 130.0 | 180.0 |

[Table 1] (continued)

| | Example 1 | | Comparative example 1 | | Comparative example 2 |
|---|---|---|---|---|---|
| Solvent | Water | | Water | | Air |
| Obtained pattern line width (nm) | 84.4 | 66.1 | 91.5 | 65.3 | 90.0 |
| Obtained pattern pitch (nm) | 178.7 | 130.1 | 184.5 | 128.4 | 177.3 |
| Exposure dose ($mJ/cm^2$) | 3.7 | 8.9 | 3.7 | 6.2 | 3.7 |
| LER (line edge roughness (nm)) | 3.0 | 4.2 | 7.5 | 8.2 | 7.6 |
| Evaluation of resist pattern profile | Good, no bridging within either resist pattern | | Poor, both resist patterns exhibited localized bridging | | Good, no bridging within resist pattern |

LER was determined by measuring the resist pattern width of a sample at 32 positions using a measuring SEM (brand name: S-9220, manufactured by Hitachi, Ltd.), and calculating the value of 3 times the standard deviation ($3\sigma$) from these measurement results. The smaller this $3\sigma$ value is, the lower the level of roughness, indicating a resist pattern with a uniform width.

As is evident from the results shown in Table 1, when a line width of 90 nm and a pitch of 180 nm were targeted in the example, the measured values of the line width and pitch obtained were the same as the results obtained for the comparative example 2 using air.

When a line width of 65 nm and a pitch of 130 nm were targeted, the comparative test using an air medium was not conducted, but values close to the target were achieved in the example, indicating that resolution was possible with no effects caused by the solvent.

Furthermore, in terms of LER, it is clear that the example yielded results that were far superior to those of the comparative example 2.

In comparison with the comparative example 1 that used triethanolamine, the resist pattern shape of the example was extremely good, with no bridging. Furthermore, the LER results were also excellent.

In the comparative examples 3 to 6, patterning was conducted by normal exposure, using either an amine that contained no polar groups but had a molecular weight of at least 200, or an amine that contained a polar group but had a molecular weight of less than 200. The fact that, on normal exposure, these amines exhibited inferior pattern shape and resolution to those of triethanolamine indicated that there was no need to conduct a comparison using immersion exposure.

Accordingly, if a resist composition of the present invention is applied to an immersion lithography process, then it is clear that in comparison with compositions that use other nitrogen-containing organic compounds, superior resist pattern profiles will be able to be obtained, and resolution will be possible down to line widths of approximately 50 nm and pitches of approximately 100 nm.

[Examples 2 to 5]

- Evaluation using measured values of X1 and X2

With the exceptions of setting the molar proportions p, q, and r for the component (A) to 40/40/20 (mol%), using 5 parts by weight of triphenylsulfonium nonafluorobutanesulfonate as the component (B), replacing the component (D) with the compound (N-1) shown in the above [formula 5] (example 2), the compound (N-2) shown in the above [formula 5] (example 3), the compound (N-3) shown in the above [formula 5] (example 4), or the compound (N-4) shown in the above [formula 5] (example 5), and using a mixed solvent of propylene glycol monomethyl ether acetate and ethyl lactate (molar ratio 6:4) in sufficient quantity to generate a total solid fraction concentration of 6% by weight as the component (C), resist compositions were prepared in the same manner as the example 1.

The compounds (N-1), (N-2), (N-3), and (N-4) were used in quantities of 0.58 parts by weight, 0.78 parts by weight, 0.55 parts by weight, and 0.69 parts by weight respectively, relative to 100 parts by weight of the component (A), thus providing the same number of mols as the triethanolamine used in the comparative example 1.

Each of these resist compositions was subjected to simulated immersion lithography using the method described below, and an evaluation was made as to whether or not the resist composition was suitable for immersion lithography.

First, an organic anti-reflective film composition AR-19 (manufactured by Shipley Co., Ltd.) was applied to the surface of a silicon wafer using a spinner, and was then baked and dried at 215°C for 60 seconds on a hotplate, thereby forming an anti-reflective film layer with a film thickness of 82 nm. The resist composition was applied to the top of the anti-reflective film using a spinner, and was then prebaked and dried on a hotplate at 115°C for 90 seconds, forming a resist layer with a film thickness of 200 nm on top of the anti-reflective film.

Next, this layer was selectively irradiated with an ArF excimer laser (193 nm) through a mask pattern, using an exposure apparatus NSR-S302B (manufactured by Nikon Corporation (NA (numerical aperture) = 0.60, 2/3 annular illumination). Then, a simulated immersion lithography treatment was conducted by dripping pure water onto the surface of the silicon wafer comprising the exposed resist layer for a period of 2 minutes at 23°C, while the wafer was rotated at 2000 rpm for 5 seconds, and then at 500 rpm for 115 seconds (simulated immersion lithography treatment).

Following spin drying, a PEB treatment was performed at 115°C for 90 seconds, and the resist layer was then developed for 60 seconds in an alkali developing liquid at 23°C. As the alkali developing liquid, a 2.38% by weight aqueous solution of tetramethylammonium hydroxide was used.

The resulting resist pattern with a 1:1 line and space pattern of 130 nm was inspected using a scanning electron microscope (SEM), and the sensitivity at that point (Eop) X2 was also determined.

On the other hand, a resist pattern was also formed using a normal exposure lithography process in which the aforementioned simulated immersion lithography treatment was not performed between the resist layer formation step and the alkali developing step, in other words, using the same method as that described above but with the exception of not conducting the simulated immersion lithography treatment, and the value of Eop was determined and used as X1. In this case, in order to aid the comparison, following the selective exposure and spin drying, a PEB treatment was performed at 115°C for 90 seconds.

Determining the absolute value from the formula [(X2/X1) - 1] x 100 revealed a value of no more than 8.0 in each case, indicating that the compositions were resistant to any effects of the immersion exposure.

Furthermore, the resist patterns were of a favorable shape with no T-top shapes and no visible surface roughness.

[Table 2]

| | Example 2 | Example 3 | Example 4 | Example 5 |
|---|---|---|---|---|
| X1 | 11.7 | 12.2 | 11.4 | 12.1 |
| X2 | 12.1 | 12.8 | 11.8 | 12.4 |
| absolute value of [(X2/X1) - 1] x 100 | 3.4 | 5.0 | 3.5 | 2.5 |

INDUSTRIAL APPLICABILITY

The present invention can be used in the formation of resist patterns, and is very useful industrially.

**Claims**

1. A photoresist composition used in a method of forming a resist pattern that comprises an immersion exposure step, comprising

    a resin component (A) that undergoes a change in alkali solubility under action of acid, an acid generator component (B) that generates acid on exposure, an organic solvent (C), and a nitrogen-containing organic compound (D) represented by a general formula (1) shown below:

[Formula 1]

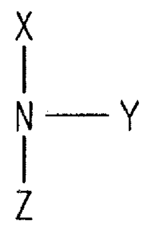

···(1)

[wherein, X, Y, and Z each represent, independently, an alkyl group that may contain an aryl group bonded to a terminal (although two terminals from said groups X, Y, and Z may also be bonded together to form a cyclic structure), at least one of X, Y, and Z comprises a polar group, and a molecular weight of said compound (D) is at least 200].

**2.** A photoresist composition according to claim 1, wherein said component (D) comprises a compound represented by a general formula (2) shown below:
[Formula 2]

$$N(R^{11}—0—R^{12}—R^{12}—0—R^{13})_3 \qquad (2)$$

(wherein, $R^{11}$ and $R^{12}$ each represent, independently, a lower alkylene group, and $R^{13}$ represents a lower alkyl group).

**3.** A photoresist composition according to claim 1, which is used in a method of forming a resist pattern in which, during said immersion exposure step, a region between a resist layer formed from said photoresist composition and a lens at a lowermost point of an exposure apparatus is filled with a solvent with a refractive index that is larger than a refractive index of air but smaller than a refractive index of said resist layer.

**4.** A photoresist composition according to claim 1, wherein said component (A) comprises no structural units (a0), including structural units (a0-1) containing an anhydride of a dicarboxylic acid, and structural units (a0-2) containing a phenolic hydroxyl group.

**5.** A photoresist composition according to claim 1, wherein said component (A) comprises structural units derived from (meth)acrylate esters.

**6.** A photoresist composition according to claim 5, wherein said component (A) comprises a structural unit (a1) derived from a (meth)acrylate ester containing an acid dissociable, dissolution inhibiting group.

**7.** A photoresist composition according to claim 5, wherein said component (A) comprises a structural unit (a2) derived from a (meth)acrylate ester containing a lactone unit.

**8.** A photoresist composition according to claim 5, wherein said component (A) comprises a structural unit (a1) derived from a (meth)acrylate ester containing an acid dissociable, dissolution inhibiting group, and a structural unit (a2) derived from a (meth)acrylate ester containing a lactone unit, and respective quantities of said structural units (a1) and (a2) are from 20 to 60 mol% for (a1) and from 20 to 60 mol% for (a2).

**9.** A photoresist composition according to any one of claim 5 through claim 8, wherein said component (A) comprises a structural unit (a3) derived from a (meth)acrylate ester containing a polycyclic group with a hydroxyl group.

**10.** A photoresist composition according to claim 5, wherein said component (A) comprises a structural unit (a1) derived from a (meth)acrylate ester containing an acid dissociable, dissolution inhibiting group, a structural unit (a2) derived from a (meth)acrylate ester containing a lactone unit, and a structural unit (a3) derived from a (meth)acrylate ester

containing a polycyclic group with a hydroxyl group, and respective quantities of said structural units (a1) through (a3) are from 20 to 60 mol% for (a1), from 20 to 60 mol% for (a2), and from 5 to 50 mol% for (a3).

**11.** A photoresist composition according to claim 5, wherein said component (A) comprises both structural units derived from methacrylate esters and structural units derived from acrylate esters.

**12.** A photoresist composition according to claim 3, wherein said solvent with a refractive index that is larger than a refractive index of air is water or a fluorine-based inert liquid.

**13.** A method of forming a resist pattern using a photoresist composition according to claim 1, which comprises an immersion exposure step.

**14.** A method of forming a resist pattern according to claim 13, wherein in said immersion exposure step, following formation of a resist layer comprising said photoresist composition, a region between said resist layer and a lens at a lowermost point of an exposure apparatus is filled with a solvent with a refractive index that is larger than a refractive index of air.

**15.** A method of forming a resist pattern according to claim 14, wherein either water or a fluorine-based inert liquid is used as said solvent with a refractive index that is larger than a refractive index of air.

## INTERNATIONAL SEARCH REPORT

International application No.
PCT/JP2004/002179

**A. CLASSIFICATION OF SUBJECT MATTER**
Int.Cl[7] G03F7/004, 7/038, 7/039

According to International Patent Classification (IPC) or to both national classification and IPC

**B. FIELDS SEARCHED**

Minimum documentation searched (classification system followed by classification symbols)
Int.Cl[7] G03F7/004-7/18, H01L21/027

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2004 |
| Kokai Jitsuyo Shinan Koho | 1971-2004 | Toroku Jitsuyo Shinan Koho | 1994-2004 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 2002-303980 A (FUJI PHOTO FILM CO., LTD.), 18 October, 2002 (18.10.02), Full text & US 2003/44715 A1 | 1-12<br>13-15 |
| X<br>Y | EP 1273970 A2 (FUJI PHOTO FILM CO., LTD.), 08 January, 2003 (08.01.03), Full text & JP 2003-98672 A | 1-12<br>13-15 |
| X<br>Y | JP 2001-194776 A (Shin-Etsu Chemical Co., Ltd.), 19 July, 2001 (19.07.01), Full text & US 6673511 B1 | 1,3-8,11-12<br>2,9,10,13-15 |

[X] Further documents are listed in the continuation of Box C. [ ] See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>16 March, 2004 (16.03.04) | Date of mailing of the international search report<br>30 March, 2004 (30.03.04) |
| Name and mailing address of the ISA/<br>Japanese Patent Office | Authorized officer |
| Facsimile No. | Telephone No. |

Form PCT/ISA/210 (second sheet) (July 1998)

**INTERNATIONAL SEARCH REPORT**

International application No.
PCT/JP2004/002179

C (Continuation). DOCUMENTS CONSIDERED TO BE RELEVANT

| Category* | Citation of document, with indication, where appropriate, of the relevant passages | Relevant to claim No. |
|---|---|---|
| X<br>Y | US 2002/115018 A1 (Hatakeyama et al.),<br>22 August, 2002 (22.08.02),<br>Full text<br>& JP 2002-249478 A | 1,3-8,11,12<br>2,9,10,13-15 |
| X<br>Y<br>A | JP 2002-363148 A (Shin-Etsu Chemical Co., Ltd.),<br>18 December, 2002 (18.12.02),<br>Full text<br>(Family: none) | 1,3-8,11,12<br>13-15<br>2 |
| X<br>Y | JP 2002-363146 A (Shin-Etsu Chemical Co., Ltd.),<br>18 December, 2002 (18.12.02),<br>Full text<br>(Family: none) | 1-8,11,12<br>9,10,13-15 |
| X<br>Y | JP 2002-179731 A (Shin-Etsu Chemical Co., Ltd.),<br>26 June, 2002 (26.06.02),<br>Full text<br>(Family: none) | 1-8,11,12<br>9,10,13-15 |
| A<br>Y | WO 99/49504 A1 (Nikon Corp.),<br>30 September, 1999 (30.09.99),<br>Full text; all drawings<br>& AU 2747999 A | 1-12<br>13-15 |
| A<br>Y | JP 11-176727 A (Nikon Corp.),<br>02 July, 1999 (02.07.99),<br>Full text; all drawings<br>(Family: none) | 1-12<br>13-15 |
| A<br>Y | JP 62-65326 A (Hitachi, Ltd.),<br>24 March, 1987 (24.03.87),<br>Full text; all drawings<br>(Family: none) | 1-12<br>13-15 |
| P,X<br>P,Y | JP 2003-149812 A (FUJI PHOTO FILM CO., LTD.),<br>21 May, 2003 (21.05.03),<br>Full text<br>(Family: none) | 1-12<br>13-15 |
| A | JP 2002-341522 A (Sumitomo Chemical Co., Ltd.),<br>27 November, 2002 (27.11.02),<br>Full text<br>(Family: none) | 1-15 |

Form PCT/ISA/210 (continuation of second sheet) (July 1998)